# EUROPÄISCHE PATENTSCHRIFT

(11) **EP 2 671 321 B1**
(45) Veröffentlichungstag und Bekanntmachung des Hinweises auf die Patenterteilung: **26.07.2017**
(21) Anmeldenummer: 12702481.8
(22) Anmeldetag: 27.01.2012
(51) Int. Cl.: H03K 17/723, H04M 19/04

(54) **WECKSCHALTUNG, WECKSCHALTUNGSANORDNUNG UND WECKVERFAHREN ZUM AKTIVIEREN EINER ELEKTRISCHEN ODER ELEKTRONISCHEN FUNKTIONSGRUPPE**
WAKE-UP CIRCUIT, WAKE-UP CIRCUIT ARRANGEMENT, AND WAKE-UP METHOD FOR ACTIVATING AN ELECTRIC OR ELECTRONIC FUNCTIONAL GROUP
CIRCUIT DE RÉVEIL, DISPOSITIF DE CIRCUIT DE RÉVEIL ET PROCÉDÉ DE RÉVEIL SERVANT À ACTIVER UN GROUPE DE FONCTIONS ÉLECTRIQUES OU ÉLECTRONIQUES

(30) Priorität: 05.02.2011 DE 102011010475
(43) Veröffentlichungstag der Anmeldung: 11.12.2013
(73) Patentinhaber: ATLAS ELEKTRONIK GmbH, 28309 Bremen (DE)
(72) Erfinder: WOLK, Klaus-Dieter, 28832 Achim (DE)
(86) Internationale Anmeldenummer: PCT/EP2012/051305
(87) Internationale Veröffentlichungsnummer: WO 2012/104207

(56) Entgegenhaltungen:
- FR-A- 1 593 436
- FR-A1- 2 154 649
- FR-A1- 2 555 840

## Beschreibung

Die Erfindung betrifft eine Weckschaltung zum Aktivieren einer elektrischen oder elektronischen Funktionsgruppe. Ferner betrifft die Erfindung eine Weckschaltungsanordnung mit der Weckschaltung und einem daran angeschlossenen Schaltelement. Schließlich betrifft die Erfindung ein Weckverfahren zum Aktivieren der elektrischen oder elektronischen Funktionsgruppe.

Die vorliegend betrachtete elektrische oder elektronische Funktionsgruppe kann wahlweise einen von zumindest zwei Zuständen einnehmen, nämlich einen Wartezustand oder einen Betriebszustand. Im Betriebszustand führt eine derartige Funktionsgruppe bspw. eine Messung durch oder erledigt andere Aufgaben. Hierfür benötigt sie in der Regel elektrische Energie. Um Energie zu sparen, kann eine derartige Funktionsgruppe bspw. in Messpausen in den Ruhezustand versetzt werden, in dem sie in der Regel weitaus weniger elektrische Energie pro Zeiteinheit bzw. eine weitaus geringere elektrische Leistung benötigt.

Zum Aufwecken der Funktionsgruppe bzw. zum Versetzen der Funktionsgruppe vom Wartezustand in den Betriebszustand wird üblicherweise ein Wecksignal an die Funktionsgruppe gesendet.

Die vorliegend betrachtete Weckschaltung ist genauer dadurch spezifiziert, dass sie eine galvanische Trennung zwischen einer Steuerseite und einer Gesteuertenseite aufweist. Insbesondere wird nämlich das Wecksignal auf der Gesteuertenseite geschaltet, wohingegen dieses Schalten auf der Steuerseite veranlasst wird. Dabei kann sich die Steuerseite auf gegenüber der Gesteuertenseite anderem elektrischen Niveau befinden. Die Weckschaltung weist daher einen galvanisch von der Schaltstufe getrennten Schalteingang zum Anschluss des die Schaltstufe schaltenden Schaltelements auf. Der Schalteingang kann dabei mehrere, vorzugsweise zwei, elektrische Anschlüsse aufweisen.

Bei bekannten Weckschaltungen erfolgt die Ansteuerung von der Steuerseite zur gesteuerten Seite üblicherweise über Optokoppler, Impulsüberträger oder induktive oder kapazitive Koppler, wie bspw. Datenkoppler, die alle auf der Ansteuerseite eine elektrische Leistung benötigten. Bekannte Weckschaltungsanordnungen benötigen daher auf der Steuerseite in der Regel einen Leistungseinsatz, der Leistung von der Gesteuertenseite zur Steuerseite überträgt. Dieser Leistungseinsatz benötigt seinerseits elektrische Energie zu seinem Betrieb und trägt damit zu einer Gesamtleistungsaufnahme der Weckschaltungsanordnung in erheblichem Maße bei.

Aus FR 2 555 840 A1 ist eine Schaltung zum Aktivieren eines elektronischen Bauteils bekannt, wobei diese Schaltung einen galvanisch vom elektronischen Bauteil getrennten Schalteingang aufweist, an den ein Schaltelement angeschlossen ist. Weiter weist diese bekannte Schaltung einen Koppeltransformator mit einer Primärseite und einer Sekundärseite auf, die elektrisch miteinander verbunden, jedoch galvanisch von einer elektrisch mit dem Schalteingang verbundenen weiteren Spulenanordnung getrennt sind. Die Stellung des Schaltelements beeinflusst über diese weitere Spulenanordnung die Koppelung der Primärseite mit der Sekundärseite des Koppeltransformators. Zur Steuerung des elektronischen Bauteils wird deshalb eine sekundärseitig wirksame Impedanz des Koppeltransformators ausgewertet.

Der Erfindung liegt die Aufgabe zugrunde, eine Weckschaltung, eine Weckschaltungsanordnung und ein Weckverfahren bereitzustellen, die ohne einen Leistungseinsatz auskommen, für die insbesondere auf der Steuerseite keine elektrische Leistung bereitgestellt werden muss.

Die Erfindung löst diese Aufgabe mit einer Weckschaltung nach Anspruch 1, mit einer Weckschaltungsanordnung nach Anspruch 3 und mit einem Weckverfahren nach Anspruch 7.

Die erfindungsgemäße Weckschaltung weist einen Koppeltransformator auf, der die Steuerseite mit der gesteuerten Seite koppelt und dadurch den Einsatz eines passiven Schaltelements ermöglicht. Die Erfindung hat nämlich erkannt, dass mittels des Schaltelements bestimmt werden kann, ob auf einer der Ansteuerungsseite zugeordneten Sekundärseite des Koppeltransformators elektrischer Strom fließt. Dadurch wird auf einer der Gesteuertenseite zugeordneten Primärseite des Koppeltransformators nämlich die wirksame Eingangsimpedanz und der Quellenstrom beeinflusst. Dies kann wiederum gemessen und dadurch der Schaltzustand des Schaltelements festgestellt und in Erwiderung darauf die Funktionsgruppe entsprechend geschaltet werden.

Die Erfindung ermöglicht somit eine extrem niedrige Leistungsaufnahme der Weckschaltung, insbesondere eine Leistungsaufnahme von bis zu 2 mW für die Funktionsgruppe mit der Weckschaltung im Ruhezustand der Funktionsgruppe.

Die Sekundärseite des Koppeltransformators ist elektrisch mit dem Schalteingang verbunden. Die Primärseite ist galvanisch von der Sekundärseite getrennt und induktiv mit der Sekundärseite gekoppelt. Mit der Primärseite ist ferner eine Kippstufe elektrisch verbunden zum zeitdiskreten Bereitstellen elektrischer Energie mit einer Spitzenleistung an der Primärseite des Koppeltransformators. Dadurch braucht dem Koppeltransformator nur periodisch wiederkehrend elektrische Energie bereitgestellt zu werden, so dass die Leistungsaufnahme der Weckschaltung gering bleibt.

Die Weckschaltung weist ferner eine Triggerstufe zum Abfragen der von der Schaltstellung des Schaltelements auf der Sekundärseite abhängigen wirksamen Impedanz an der Primärseite des Koppeltransformators und zum Ansteuern der Schaltstufe in Abhängigkeit dieser abgefragten wirksamen Impedanz auf. Insbesondere entscheidet die Triggerstufe anhand der abgefragten wirksamen Impedanz, ob das Schaltelement auf der Sekundärseite geschaltet ist oder nicht.

Das erfindungsgemäße Weckverfahren weist demgemäß folgende Schritte auf:
- Schalten der Funktionsgruppe mittels des Schaltelements über den galvanisch von der Schaltstufe getrennten Schalteingang,
- zeitdiskretes Bereitstellen elektrischer Energie mit der Spitzenleistung an der Primärseite des Koppeltransformators mittels der Kippstufe,
- Induzieren elektrischen Stroms mittels eines von der Primärseite erzeugten Magnetfelds auf der elektrisch mit dem Schalteingang und dem geschlossenen Schaltelement verbundenen Sekundärseite des Koppeltransformators,
- Abfragen der wirksamen Impedanz auf der Sekundärseite des Koppeltransformators mittels der Triggerstufe und
- Schalten der Funktionsgruppe in Abhängigkeit von der abgefragten wirksamen Impedanz an der Primärseite des Koppeltransformators.

Dabei macht sich die Erfindung zu Nutze, dass das Induzieren des elektrischen Stroms mittels des Magnetfelds bei dem geschlossenen Schaltelement folgende weitere Schritte bewirkt:
- Entgegenwirken gegen das Magnetfeld durch den Induzierten Strom und
- Erhöhen des Quellenstroms und Vermindern der wirksamen Impedanz an der Primärseite des Koppeltransformators zum Aufrechterhalten des Magnetfelds.

Wenn das Schaltelement geöffnet ist, wird auf der Sekundärseite eine Spannung erzeugt, es fließt jedoch kein Strom. Wenn dagegen das Schaltelement geschlossen ist, fließt dagegen Strom, wohingegen keine Spannung anliegt. Der Stromfluss bewirkt ein Magnetfeld, das dem vom Strom auf der Primärseite erzeugten Magnetfeld entgegenwirkt. Dies hat automatisch zur Folge, dass von der Primärseite aus versucht wird, durch Bereitstellung zusätzlicher Energie das erzeugte Magnetfeld aufrechtzuerhalten. Dadurch sinkt die wirksame Eingangsimpedanz auf der Primärseite des Koppeltransformators, wohingegen sich der Quellenstrom auf der Primärseite erhöht. Dies macht sich die Erfindung zu Nutze, in dem sie das Schalten der Funktionsgruppe von der festgestellten wirksamen Eingangsimpedanz an der Primärseite des Koppeltransformators abhängig macht und somit das Wecksignal in Abhängigkeit von der Schaltstellung des Schaltelements auf der Steuerseite erzeugt.

Die Kippstufe weist vorzugsweise einen Energiespeicher zum Speichern der elektrischen Energie und zum Bereitstellen dieser elektrischen Energie mit der Spitzenleistung auf. Der Energiespeicher ist vorzugsweise ein Speicherkondensator. Gemäß dem erfindungsgemäßen Weckverfahren wird die elektrische Energie vorzugsweise im Energiespeicher gespeichert und die gespeicherte Energie danach mit der Spitzenleistung bereitgestellt. Aufgrund des Energiespeichers wird die maximale Leistungsaufnahme der Weckschaltung gering gehalten, indem die kurzzeitig hohe Energie für Leistungsspitzen aus dem Energiespeicher entnommen wird.

Vorzugsweise weist die Kippstufe ferner eine elektrische Entladeverbindung zwischen dem Energiespeicher und der Primärseite des Koppeltransformators zum Entladen des Speicherkondensators zum Koppeltransformator auf. In dieser Entladeverbindung ist vorzugsweise ein Entladeschalter zum zeitdiskreten Freischalten der Entladeverbindung angeordnet. Das erfindungsgemäße Weckverfahren weist entsprechend vorzugsweise den Schritt "Entladen des Speicherkondensators zur Primärseite des Koppeltransformators über die elektrische Entladeverbindung" sowie vorzugsweise den Schritt "zeitdiskretes Freischalten der Entladeverbindung mittels des Entladeschalters" auf. Auf diese Weise kann, vorzugsweise periodisch, der Koppeltransformator mit elektrischer Energie versorgt und dadurch der jeweilige Schaltzustand des Schaltelements abgefragt werden.

Vorzugsweise erfolgt ein Ansteuern des Entladeschalters mittels eines Impulsgebers. Die Kippstufe weist somit vorzugsweise diesen Impulsgeber zum Ansteuern des Entladeschalters auf. Auf diese Weise erfolgt eine zweckmäßige elektronische Ansteuerung des Entladeschalters.

Vorzugsweise steuert der Impulsgeber den Entladeschalter in Abhängigkeit einer Ladezeitdauer bzw. in Abhängigkeit eines Ladezustands des Speicherkondensators an. Bspw. wird festgestellt, dass der Energiespeicher bzw. Speicherkondensator vollständig geladen ist und in Erwiderung darauf mittels des Impulsgebers der Entladeschalter zum Entladen des Energiespeichers geschaltet. Auf diese Weise wird immer gleichmäßig Leistung zum Laden des Kondensators aufgewendet.

Die erfindungsgemäße Weckschaltungsanordnung umfasst die erfindungsgemäße Weckschaltung und zumindest das an deren Schalteingang angeschlossene Schaltelement.

Das Schaltelement ist vorzugsweise ein passives Schaltelement. Insbesondere ist das Schaltelement bspw. ein passiver mechanischer Schalter oder ein passiver Halbleiterschalter oder ein sonstiges passives Bauelement mit Schaltcharakteristik. Der passive Halbleiterschalter ist bspw. ein sog. "Open-Collector-Ausgang" oder ein sog. "Open-Drain-Ausgang". Ferner besteht die elektrische Verbindung des Schaltelements zur Weckschaltung vorzugsweise ausschließlich zur Sekundärseite des Koppeltransformators. Damit ist eine vollständige galvanische Trennung zwischen der Weckschaltung und dem Schaltelement gegeben.

Das erfindungsgemäße Weckverfahren umfasst entsprechend ein passives, insbesondere leistungsloses, Betätigen des Schaltelements, insbesondere ein passives mechanisches Betätigen oder passives elektrisches oder elektronisches Betätigen oder sonstiges leistungsloses Auslösen eines Schaltvorgangs am Schaltelement, wobei das geschaltete Schaltelement im Wesentlichen widerstandslos Strom durchleitet. Im Schaltelement muss somit vorzugsweise keinerlei elektrische Energie zugeführt werden, um eine Information über seinen Schaltzustand zur Weckvorrichtung zu übertragen.

Die Sekundärseite des Koppeltransformators, der Schalteingang und das Schaltelement sind vorzugsweise in einem gemeinsamen Stromkreis angeordnet, in welchem Strom im Wesentlichen widerstandslos fließen kann, wenn dieser Stromkreis geschlossen ist. Dabei kann dieser Schaltkreis mittels des Schaltelements zum Schalten der Funktionsgruppe in Kurzschlussanordnung geschlossen werden. Im erfindungsgemäßen Weckverfahren ergibt sich demgemäß ein im Wesentlichen widerstandsloses Fließen elektrischen Stroms durch den mittels des geschalteten Schaltelements geschlossenen Stromkreises. Dadurch wird bewirkt, dass sich ein vergleichsweise hoher Strom aufbauen kann, der entsprechend stark dem vom Strom auf der Primärseite erzeugten Magnetfeld entgegen wirkt, so dass dadurch eine besonders deutliche Änderung der wirksamen Eingangsimpedanz auf der Primärseite des Koppeltransformators erfolgt, die besonders gut detektiert und zur Entscheidung, ob das Schaltelement betätigt oder unbetätigt ist, herangezogen werden kann. Die Triggerstufe ist auf diese Weise eindeutig schaltbar.

Vorzugsweise weist die Weckschaltungsanordnung eine Schaltstufe zum Schalten der Funktionsgruppe auf. Die Schaltstufe ist der Triggerstufe nachgeschaltet und wird von dieser Triggerstufe zum Schalten der Funktionsgruppe angesteuert. Die Schaltstufe sorgt für eine Verstärkung zu schaltender elektrischer Ströme, um den Leistungsbedarf der Funktionsgruppe decken zu können.

Die Triggerstufe steuert die Schaltstufe dabei in Erwiderung auf die Abfrage der wirksamen Impedanz auf der Primärseite des Koppelkondensators bei geschlossenem Schaltelement bzw. wenn das Schaltelement von der Triggerstufe als geschlossen erkannt wird, an.

Vorzugsweise versetzt die Schaltstufe die Funktionsgruppe in Erwiderung auf die Abfrage der wirksamen Impedanz auf der Primärseite des Koppeltransformators bei dem geschlossenen Schaltelement von ihrem Ruhezustand in ihrem Betriebszustand. Auf diese Weise ist es möglich, die Funktionsgruppe für eine lange Zeit in Wartestellung zu belassen, wenn bspw. die zur Versorgung der Funktionsgruppe und der Weckschaltung erforderliche elektrische Energie begrenzt ist, wie bspw. bei einem Batteriebetrieb, bei dem ein Nachladen der Batterie nicht möglich ist, und dennoch die Funktionsgruppe mittels des galvanisch getrennten passiven Schaltelements zuverlässig zu betätigen.

Weitere Ausführungsformen ergeben sich aus den Ansprüchen sowie aus dem anhand der Zeichnung näher erläuterten Ausführungsbeispiel. In der Zeichnung zeigen:
- Fig. 1: ein Blockschaltbild einer Weckschaltung in einer Weckschaltungsanordnung gemäß einem Ausführungsbeispiel der Erfindung nebst einer gesteuert Funktionsgruppe;
- Fig. 2: ein detailliertes Schaltbild der Weckschaltung und der Weckschaltungsanordnung des Ausführungsbeispiels gemäß Fig. 1 nebst der gesteuerten Funktionsgruppe und
- Fig. 3: ein Blockschaltbild zur Veranschaulichung des Weckverfahrens gemäß einem Ausführungsbeispiel der Erfindung.

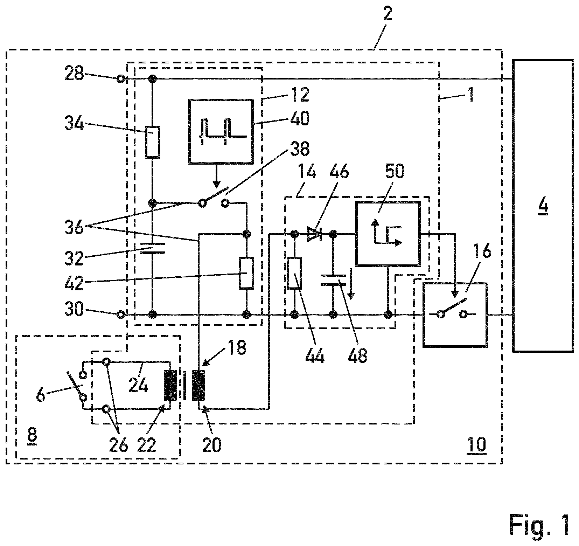

Fig. 1 zeigt eine Weckschaltung 1 in einer Weckschaltungsanordnung 2 zum Steuern bzw. Schalten einer elektrischen oder elektronischen Funktionsgruppe 4. Diese Funktionsgruppe 4 ist bspw. eine Messeinrichtung zum Messen von Meeresströmungen über einen langen Zeitraum, die zusammen mit einem Energiespeicher, bspw. einer Batterie, unterhalb der Wasseroberfläche in einem Gewässer angeordnet ist und aufgrund begrenzter Kapazität dieser Batterie außerhalb von Messzeiträumen von einem Betriebszustand in einen Ruhezustand versetzt werden kann, in welchem die Funktionsgruppe 4 und die Weckschaltungsanordnung 2 zusammen über eine geringe mittlere elektrische Leistungsaufnahme von bis zu 2 mW, vorzugsweise weniger als 1 mW, verfügen.

Die Funktionsgruppe 4 wird mittels eines passiven Schaltelements 6 geschaltet bzw. vom Ruhezustand in ihren Betriebszustand versetzt. Dieses passive Schaltelement 6 ist auf einer Steuerseite 8 der Weckschaltungsanordnung 2 angeordnet, die galvanisch von einer Gesteuertenseite 10 dieser Weckschaltungsanordnung 2 getrennt ist. Die Gesteuertenseite 10 weist dabei eine Kippstufe 12, eine Triggerstufe 14 und eine Schaltstufe 16 auf. Die Funktionsgruppe 4 ist zwar außerhalb der Weckschaltungsanordnung 2 angeordnet, kann ansonsten jedoch ebenfalls der Gesteuertenseite 10 zugerechnet werden, da eine elektrische Verbindung zwischen der Schaltstufe 16 und der Funktionsgruppe 4 besteht.

Die Weckschaltung 1 weist die Kippstufe 12, die Triggerstufe 14 und einen Koppeltransformator 18 auf, dessen Primärseite 20 der Gesteuertenseite 10 und dessen Sekundärseite 22 der Steuerseite 8 zugeordnet sind. Über den Koppeltransformator 18 ist das passive Schaltelement 6 mit der Gesteuertenseite 10 der Weckschaltungsanordnung gekoppelt. Dabei stellt der Koppeltransformator 18 eine induktive Kopplung zwischen seiner Primärseite 20 und seiner Sekundärseite 22 her.

Das passive Schaltelement 6 ist in einem vollständig auf der Steuerseite 8 angeordneten Stromkreis 24 angeordnet. Dieser Stromkreis 24 umfasst die Sekundärseite 22 des Koppeltransformators 18 bzw. eine auf der Sekundärseite 22 angeordnete Spule 22, mit dieser Spule 22 elektrisch verbundene Anschlüsse, die zusammen einen Schalteingang 26 definieren, und das mit dem Schalteingang 26 elektrisch verbundene passive Schaltelement 6. Mittels des Schaltelements 6 kann der Stromkreis 24 geöffnet oder geschlossen werden. Dabei ist unter dem passiven Schaltelement 6 jegliche Vorrichtung zu verstehen, die in der Lage ist, den Stromkreis 24 zu schließen, ohne hierfür Energie über den Stromkreis 24 beziehen zu müssen. Der Stromkreis 24 verfügt daher auch über keinen Anschluss zu einer Energieversorgung.

Insbesondere verfügt der Stromkreis 24 über keinen Anschluss zu einer nicht dargestellten Energieversorgungseinrichtung, wie bspw. einer Batterie, die über elektrische Anschlüsse 28 und 30 zumindest die Weckschaltung 1, vorzugsweise jedoch die gesamte Weckschaltungsanordnung 2 jeweils auf der Gesteuertenseite 10 und besonders bevorzugt auch die Funktionsgruppe 4 mit elektrischer Energie und insbesondere mit einer Spannung versorgt. Bevorzugt ist eine Spannung von 48 V zwischen den elektrischen Anschlüssen 28 und 30 vorgesehen, wobei am Anschluss 28 positive 48 V und am Anschluss 30 0 V anliegen.

Die Primärseite 20 des Koppeltransformators 18 wird über die Kippstufe 12 nicht kontinuierlich, sondern periodisch wiederkehrend angesteuert. Während einer Ansteuerung wird eine Spitzenleistung benötigt, wohingegen in den dazwischenliegenden Zeiträumen keine Leistungsbereitstellung für den Koppeltransformator 18 benötigt wird. Die erfindungsgemäße Weckschaltung sorgt insgesamt für eine geringe maximale Leistungsaufnahme sowie insgesamt für eine geringe mittlere Leistungsaufnahme durch die Weckschaltung 1, in dem sie bei geringer Leistungsaufnahme einen Speicherkondensator 32 über einen Widerstand 34 auflädt und die erforderliche Spitzenleistung, insbesondere in einem Nadelimpuls, aus diesem Speicherkondensator 32 bereitstellt. Die Bereitstellung erfolgt dabei über eine Entladeverbindung 36, in der ein Entladeschalter 38 zum periodischen Durchschalten der Entladeverbindung 36 angeordnet ist.

Der Entladeschalter 38 wird von einem Impulsgeber 40 angesteuert. Dieser Impulsgeber 40 generiert einen Schaltimpuls zum Durchschalten des Entladeschalters 38. In diesem Ausführungsbeispiel generiert der Impulsgeber 40 den Schaltimpuls in Abhängigkeit vom Ladezustand des Speicherkondensators 32. Alternativ oder zusätzlich kann der Impulsgeber jedoch auch eine Echtzeituhr (RTC = Real Time Clock) aufweisen und den Entladeschalter in vorgegebenen oder vorgebbaren Zeitabständen ansteuern.

Wenn der Entladeschalter 38 geschlossen ist, wird der Speicherkondensator 32 über diesen Entladeschalter 38 und weiter über einen Widerstand 42 sowie parallel zu diesem Widerstand 42 in Reihe geschaltet über die Primärseite 20 des Koppeltransformators 18 bzw. über eine an der Primärseite 20 des Koppeltransformators 18 angeordnete Spule und weiter über einen Widerstand 44 entladen. Während des Entladens entsteht eine Impulsspannung, die somit parallel am Widerstand 42 und an der Sekundärseite 22 des Koppeltransformators 18 zusammen mit dem Widerstand 44 anliegt. Die Spannung, die über den Widerstand 44 abfällt, hängt somit von der wirksamen Eingangsimpedanz auf der Primärseite 20 des Koppeltransformators 22 ab. Diese wirksame Eingangsimpedanz wird folgendermaßen durch die Schalterstellung des passiven Schaltelements 6 beeinflusst:
Wenn das Schaltelement 6 und somit auch der Stromkreis 24 geöffnet sind, induziert der Koppeltransformator 18 zwar eine Spannung im geöffneten Stromkreis 24, die bspw. zwischen den Anschlüssen des Schalteingangs 26 messbar wäre. Jedoch fließt kein Strom, so dass sich auch auf der Primärseite 20 des Koppeltransformators 18 ein niedriger Quellenstrom und eine hohe Eingangsimpedanz ergibt.

Wenn dagegen der Stromkreis 24 mittels des passiven Schaltelements 6 geschlossen ist, wird im Idealfall, dass der Stromkreis 24 ausschließlich ideale Leiter aufweist, die dem Strom keinen Widerstand entgegensetzen, keine Spannung, jedoch ein hoher Strom im Stromkreis 24 induziert. Tatsächlich wird der Schaltkreis dem Strom in der Praxis einen geringen Widerstand entgegensetzen. Die Erfindung ist jedoch bestrebt, insbesondere durch die Wahl das passiven Schaltelements 6, diesen Widerstand möglichst gering zu halten. Der Strom im Stromkreis 24 erzeugt mittels der Sekundärseite 22 des Koppeltransformators 18 ein Magnetfeld, das dem von der Primärseite 20 des Koppeltransformators 18 hervorgerufenen Magnetfeld entgegenwirkt. Dadurch erhöht sich automatisch der Quellenstrom auf der Primärseite 20 des Koppeltransformators 18, wohingegen die wirksame Eingangsimpedanz des Koppeltransformators 18 sinkt.

Insgesamt ergibt sich somit in Abhängigkeit von der Schaltstellung des passiven Schaltelements 6 bzw. in Abhängigkeit davon, ob der Stromkreis 24 geöffnet oder geschlossen ist, eine unterschiedlich hohe wirksame Eingangsimpedanz auf der Primärseite 20 des Koppeltransformators 18. In Abhängigkeit davon ändert sich ebenfalls der Anteil der Spannung, der am Widerstand 44 abfällt, da der Gesamtabfall der Spannung erhalten bleibt und sich lediglich unterschiedlich verteilt.

Die in Abhängigkeit von der Schaltstellung des passiven Schaltelements 6 am Widerstand 44 abfallenden Spitzenspannung wird über eine Entkoppeldiode 46 einem Kondensator 48 zugeführt und in diesem Kondensator 48 gespeichert. Die Entkoppeldiode 46 sorgt dafür, dass sich der Kondensator nach einem Abfallen der Spitzenspannung nicht über den Widerstand 44 entlädt.

Die Triggerstufe 14 weist den Widerstand 44, die Entkoppeldiode 46, den Kondensator 48 und ein Triggerelement 50 auf. Das Triggerelement 50 entscheidet anhand der am Kondensator 48 anliegenden Spannung, ob das passive Schaltelement 6 betätigt oder unbetätigt ist. Wenn das Triggerelement 50 bzw. die Triggerstufe 14 entschieden bzw. erkannt hat, dass das passive Schaltelement 6 betätigt ist, steuert das Triggerelement 50 bzw. die Triggerstufe 14 die Schaltstufe 16 derart an, dass diese Schaltstufe 16 durchschaltet und die Schaltstufe 16 dadurch die elektrisch mit der Schaltstufe 16 verbundene Funktionsgruppe 4 aufweckt bzw. vom Ruhezustand in den Betriebszustand versetzt.

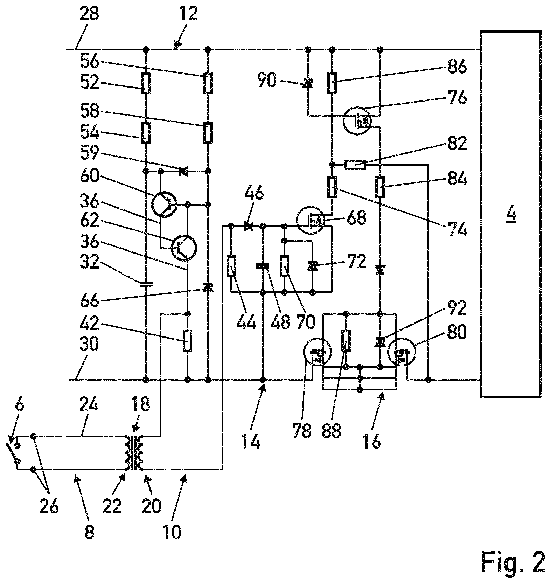

Fig. 2 zeigt ein Schaltbild des ersten Ausführungsbeispiels der Erfindung gemäß Fig. 1, welches gegenüber dem Blockschaltbild von Fig. 1 mehr Details des Ausführungsbeispiels offenbart.

Der Speicherkondensator 32 wird über in Reihe geschaltete Widerstände 52 und 54 sowie parallel dazu über in Reihe geschaltete Widerstände 56 und 58 in Reihe mit einer Diode 59 geladen, die somit alle zusammen den Widerstand 34 gemäß Fig. 1 bilden. Zwei Transistoren, nämlich ein sog. pnp-Transistor 60 mit einer negativen Basis und ein sog. npn-Transistor 62 mit einer positiven Basis bilden zusammen mit der Diode 59 und mit einer Zenerdiode 66 die Kombination aus Impulsgeber 40 und Entladeschalter 38 gemäß Fig. 1. Die Zenerdiode 66 bewirkt, dass mit größer werdendem Ladezustand des Speicherkondensators 32 ab Erreichen der Zenerspannung der Spannungsabfall zwischen dem Emitter und der Basis des Transistors 60 zunehmend größer wird, bis der Transistor 60 schließlich zu seinem Collector durchschaltet, so dass nachfolgend an der Basis des Transistors 62 eine gegenüber dessen Emitter eine positive Spannung anliegt, die wiederum den Transistor 62 von seinem Collector zum Emitter durchschaltet.

Die Diode 59 dient dazu, mit ihrer Flussspannung die bei noch nicht durchgeschaltetem Transistor 60 zwischen dessen Basis und Emitter zunächst in Sperrrichtung auftretende Spannung auf einen unkritischen Wert zu begrenzen. Insgesamt wird der Speicherkondensator 32 somit ab Erreichen eines Speicherzustands, der den Spannungsabfall zwischen dem Emitter und der Basis des Transistors 60 groß genug werden lässt, über diesen Transistor 60 und den Transistor 62 unter anderem zum Koppeltransformator 18 entladen.

Das Triggerelement 50 der Triggerstufe 14 weist einen Metall-Oxid-Halbleiter-Fotoeffekttransistor (MOSFET = Metal Oxide Semiconductor Field-Effect Transistor) 68 in selbstsperrender Bauart auf. Ferner weist das Triggerelement 50 einen Entladewiderstand 70 zum allmählichen Abbauen der Spannung am Kondensator 48 und eine Zenerdiode 72 auf, welche zum Schutz des MOSFETs zu hohe Spannungsspitzen abbaut. Ferner ist dem MOSFET noch ein Widerstand 74 als Teil des Triggerelements 50 nachgeschaltet, über den die Schaltstufe 16 angesteuert wird.

Die Schaltstufe 16 weist weitere MOSFETs 76, 78 und 80 auf, um die für die Funktionsgruppe 4 benötigte Leistung schalten zu können. Zusammen mit weiteren Widerständen 82, 84, 86 und 88 wirken die MOSFETs 76, 78 und 80 somit als Verstärker schaltbarer Ströme. Die MOSFETs 78 und 80 bilden dabei den eigentlichen Leistungsschalter für den Betriebsstrom der Funktionsgruppe 4. Der MOSFET 78 erfüllt hierbei auch die Funktion eines aktiven Verpolungsschutzes für den Fall, dass an den Versorgungsanschlüssen 28 und 30 irrtümlich eine verpolte Versorgungsspannung angelegt sein sollte. Der MOSFET 80 kann für sich allein diese Funktion dagegen nicht übernehmen, da seine Substratdiode im Falle einer Verpolung permanent leitend wäre. Ferner sind wiederum Zenerdioden 90 und 92 vorgesehen, welche die MOSFETs 76, 78 und 80 vor Überspannung schützen. Eine Diode 90 sorgt schließlich für ein ausreichendes Potentialgefälle zwischen dem Emitter und der Basis des MOSFETs 76.

Die Schaltstufe 16 weist eine Selbsthaltefunktion auf, wobei sie nach einer Aktivierung durch die Triggerstufe 14 durchgeschaltet bleibt, auch wenn die Triggerstufe 14 das Schaltelement 6 nicht mehr als geschlossen erkennt und die Schaltstufe demgemäß nicht mehr entsprechend ansteuert. Ein Zurücksetzen der Funktionsgruppe 4 vom Betriebszustand in den Ruhezustand kann in diesem Fall lediglich mittels hier nicht dargestellter Rückschaltmittel erfolgen.

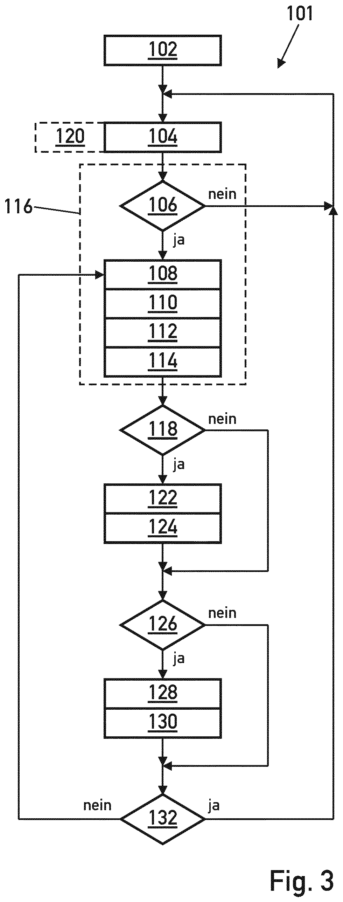

Fig. 3 zeigt ein Weckverfahren 101 gemäß einem Ausführungsbeispiel der Erfindung. Nach einem Start 102 des Verfahrens folgt in einem Schritt 104 das Speichern elektrischer Energie im Energiespeicher bzw. Speicherkondensator 32. Dieses Aufladen des Speicherkondensators 32 wird solange fortgesetzt, bis der Impulsgeber 40 einen Impuls zum Entladen des Speicherkondensators 32 liefert bzw. bis die Kapazität des Speicherkondensators 32 einen Schwellenwert übersteigt. Demgemäß folgt in einem Schritt 106 die Abfrage, ob der Ladezustand des Speicherkondensators 32 diesen Schwellenwert übersteigt oder nicht. Solange dies nicht der Fall ist, wird mit dem Laden des Speicherkondensators 32 im Schritt 104 fortgefahren.

Wenn jedoch ein ausreichender Ladezustand festgestellt ist, folgt in einem Schritt 108 ein Ansteuern des in der elektrischen Entladeverbindung 36 zwischen dem Speicherkondensator 32 und dem Koppeltransformator 18 angeordneten Entladeschalters 38 mittels des Impulsgebers 40. In Erwiderung auf diese Ansteuerung wird in einem Schritt 108 ein zeitdiskretes Freischalten der Entladeverbindung 36 mittels des Entladeschalters 38 ausgelöst. Dies führt in einem Schritt 112 zum Entladen des Speicherkondensators 32 zur Primärseite 20 des Koppeltransformators 18 über die elektrische Entladeverbindung 36. Dies bewirkt gemäß einem Schritt 114 ein Bereitstellen der gespeicherten Energie mit der erforderlichen Spitzenleistung. Die Schritte 106 bis 114 lassen sich dabei zu einem Schritt 116 zusammenfassen, nämlich einem zeitdiskreten Bereitstellen elektrischer Energie mit der Spitzenleistung an der Primärseite 20 des Koppeltransformators 18 mittels der Kippstufe 12.

Die weiteren Auswirkungen des Verfahrens unterscheiden sich, je nachdem, ob gemäß einer Frage 118 das Schaltelement 6 betätigt ist oder nicht. Nun sei angenommen, dass Schaltelement 8 sei in einem Schritt 120 betätigt worden und befände sich weiterhin in dieser betätigten Schaltstellung. Das Betätigen kann bspw. während des Ladevorgangs des Speicherkondensators 32 im Schritt 104 stattgefunden haben. In diesem Fall wird gemäß einem Schritt 122 ein elektrischer Strom mittels des von der Primärseite 20 des Koppeltransformators 18 erzeugten Magnetfeldes auf der Sekundärseite 22 bzw. in dem mittels des Schaltelements 6 geschlossenen Stromkreises 24 induziert. Gemäß einem Schritt 124 fließt somit ein elektrischer Strom durch die Sekundärseite 22 des Koppeltransformators 18, durch den Schalteingang 26 und durch das geschaltete Schaltelement 6 bzw. durch den geschlossenen Stromkreis 24.

Unabhängig davon, ob das Schaltelement 6 geschlossen ist oder nicht, folgt nun nach dem Schritt 124 bzw. im Falle des nicht geschlossenen Schaltelements 6 nach dem Schritt 114 eine, insbesondere dauerhaft durchgeführte, Abfrage 126, der wirksamen Impedanz auf der Sekundärseite 20 des Koppeltransformators 18 mittels der Triggerstufe 14. Wenn gemäß dieser Abfrage 126 die festgestellte wirksame Impedanz einen Schwellenwert untersteigt bzw. die Spannung am Widerstand 44 einen Schwellenwert übersteigt, schaltet die Triggerstufe 14 durch und entscheidet damit, dass das Schaltelement 6 betätigt ist. Demgemäß folgt in einem Schritt 128 ein Schalten der Funktionsgruppe 4, insbesondere mittels der Schaltstufe 16, in Abhängigkeit von der abgefragten wirksamen Impedanz an der Primärseite 20 des Koppeltransformators 18. Damit wird gemäß einem Schritt 130 in Erwiderung auf die unter einem Grenzwert liegende festgestellte wirksame Impedanz auf der Primärseite 20 des Koppeltransformators 18 die Funktionsgruppe 4 vom Ruhezustand in den Betriebszustand versetzt.

Wenn hingegen die Triggerstufe 14 anhand der im Schritt 126 abgefragten wirksamen Impedanz entscheidet, dass das Schaltelement 6 nicht betätigt ist, entfallen die Schritte 128 und 130. Abschließen wird, wenn gemäß einer Frage 132 der Entladevorgang noch nicht abgeschlossen ist, das Entladen des Speicherkondensators 32 fortgesetzt. Andernfalls, wenn gemäß der Frage 132 der Entladevorgang abgeschlossen ist, wird der Speicherkondensator 32 gemäß dem Schritt 104 erneut geladen.

Die Erfindung ermöglicht in vorteilhafterweise Weise das Aufwecken der Funktionsgruppe 4 mittels einer energiesparenden bzw. mittels einer nur eine geringe Leistungsaufnahme benötigenden Weckschaltung mittels eines passiven, galvanisch von der Funktionsgruppe 4 getrennten Schaltelements.

Alle in der vorstehenden Beschreibung und in den Ansprüchen genannten Merkmale sind sowohl einzeln als auch in beliebiger Kombination miteinander einsetzbar. Die Offenbarung der Erfindung ist somit nicht auf die beschriebenen bzw. beanspruchten Merkmalskombinationen beschränkt. Vielmehr sind alle Merkmalskombinationen als offenbart zu betrachten.

## Patentansprüche

1. Weckschaltung zum Aktivieren einer elektrischen oder elektronischen Funktionsgruppe (4), aufweisend einen galvanisch von der Funktionsgruppe (4) getrennten Schalteingang (26) zum Anschluss eines die Funktionsgruppe (4) schaltenden Schaltelements (6),
einen Koppeltransformator (18) mit einer elektrisch mit dem Schalteingang (26) verbundenen Sekundärseite (22) und mit einer galvanisch von der Sekundärseite (22) getrennten und induktiv mit der Sekundärseite (22) gekoppelten Primärseite (20), eine elektrisch mit der Primärseite (20) verbundene Kippstufe (12) zum zeitdiskreten Bereitstellen elektrischer Energie mit einer Spitzenleistung an der Primärseite (20) des Koppeltransformators (18) und
eine Triggerstufe (14) zum Abfragen der von der Schaltstellung des Schaltelements (6) auf der Sekundärseite (22) abhängigen wirksamen Impedanz an der Primärseite (20) des Koppeltransformators (18) und zum Ansteuern der Funktionsgruppe (4) in Abhängigkeit dieser abgefragten wirksamen Impedanz, **dadurch gekennzeichnet, dass** die Primärseite aus einer Spule besteht.

2. Weckschaltung nach Anspruch 1,
**dadurch gekennzeichnet, dass**
die Kippstufe (12) aufweist:
einen Energiespeicher (32) zum Speichern der elektrischen Energie und zum Bereitstellen dieser elektrischen Energie mit der Spitzenleistung,
eine elektrische Entladeverbindung (36) zwischen dem Energiespeicher (32) und der Primärseite (20) des Koppeltransformators (18) zum Entladen des Energiespeichers (32) zum Koppeltransformator (18),
einen Entladeschalter (38) in dieser elektrischen Entladeverbindung (36) zum zeitdiskreten Freischalten der Entladeverbindung (36) und
einen Impulsgeber (40) zum Ansteuern des Entladeschalters (38).

3. Weckschaltungsanordnung mit einer Weckschaltung (1) nach Anspruch 1 oder 2 und mit einem an deren Schalteingang (26) angeschlossenen Schaltelement (6).

4. Weckschaltungsanordnung nach Anspruch 3,
**dadurch gekennzeichnet, dass**
dieses Schaltelement (6) ein passives Schaltelement ist, dessen elektrische Verbindung zur Weckschaltung (1) ausschließlich zur Sekundärseite (22) des Koppeltransformators (18) besteht.

5. Weckschaltungsanordnung nach Anspruch 3 oder 4,
**gekennzeichnet durch**
eine Anordnung der Sekundärseite (22) des Koppeltransformators (18), des Schalteingangs (26) und des Schaltelements (6) in einem gemeinsamen Stromkreis (24), der mittels des Schaltelements (6) zum Schalten der Funktionsgruppe (4) in Kurzschlussanordnung schließbar ist, zum im Wesentlichen widerstandslosen Fließenlassen elektrischen Stroms durch diesen Stromkreis (24).

6. Weckschaltungsanordnung nach einem der Ansprüche 3 bis 5,
**gekennzeichnet durch**
eine der Triggerstufe (14) nachgeschaltete Schaltstufe (16) zum Schalten der Funktionsgruppe (4).

7. Weckverfahren zum Aktivieren einer elektrischen oder elektronischen Funktionsgruppe (4), wobei diese Funktionsgruppe (4) mittels eines Schaltelements (6) über einen galvanisch von der Funktionsgruppe (4) getrennten Schalteingang (26) geschaltet wird,
**gekennzeichnet durch** die Schritte
- zeitdiskretes Bereitstellen (116) elektrischer Energie mit einer Spitzenleistung an einer Primärseite (20) des Koppeltransformators (18) mittels einer Kippstufe (12), wobei die Primärseite aus einer Spule besteht,
- Induzieren (122) elektrischen Stroms mittels eines von der Primärseite (20) erzeugten Magnetfeldes auf einer elektrisch mit dem Schalteingang (26) und dem geschlossenen Schaltelement (6) verbundenen Sekundärseite (22) des Koppeltransformators (18),
- Abfragen (126) der wirksamen Impedanz auf der Sekundärseite (22) des Koppeltransformators (18) mittels einer Triggerstufe (14) und
- Schalten (128) der Funktionsgruppe (4) in Abhängigkeit von der abgefragten wirksamen Impedanz an der Primärseite (20) des Koppeltransformators (18).

8. Weckverfahren nach Anspruch 7,
**gekennzeichnet durch** die Schritte
- Speichern (104) elektrischer Energie in einem Energiespeicher (32),
- Bereitstellen (114) der gespeicherten Energie mit der Spitzenleistung,
- Entladen (122) des Energiespeichers (32) zur Primärseite (20) des Koppeltransformators (18) über eine elektrische Entladeverbindung (36),
- Ansteuern (118) eines in einer elektrischen Entladeverbindung (36) zwischen dem Speicherkondensator (32) und dem Koppeltransformator (18) angeordneten Entladeschalters (38) mittels eines Impulsgebers (40) und
- zeitdiskretes Freischalten (110) der Entladeverbindung (36) mittels des Entladeschalters (38).

9. Weckverfahren nach Anspruch 7 oder 8,
**gekennzeichnet durch** ein mechanisch, elektrisch oder elektronisch passives Betätigen (126) des Schaltelements (6), wobei das geschaltete Schaltelement (6) im Wesentlichen widerstandslos Strom durchleitet.

10. Weckverfahren nach einem der Ansprüche 7 bis 9,
**gekennzeichnet durch**
ein im Wesentlichen widerstandsloses Fließen (124) elektrischen Stroms durch einen die Sekundärseite (22) des Koppeltransformators (18), den Schalteingang (26) und das Schaltelement (6) aufweisenden, mittels des geschalteten Schaltelements (6) geschlossenen Stromkreis (26).

11. Weckverfahren nach einem der Ansprüche 7 bis 10,
**dadurch gekennzeichnet, dass**
die Triggerstufe (14) eine Schaltstufe (16) ansteuert, welche die Funktionsgruppe (4) in Erwiderung auf die Abfrage (126) der wirksamen Impedanz auf der Primärseite (20) des Koppelkondensators (18) bei geschlossenem Schaltelement (6) mittels des Wecksignals von einem Ruhezustand in einen Betriebszustand versetzt (130).

## Claims

1. Wake-up circuit for activating an electric or electronic functional group (4), comprising a switching input (26) galvanically separated from the functional group (4) and for connecting a switching element (6) which switches the functional group (4),
a coupling transformer (18) with a secondary side (22) electrically connected to the switching input (26) and with a primary side (20) galvanically separated from the secondary side (22) and inductively coupled to the secondary side (22),
a flip-flop (12) electrically connected to the primary side (20) for making electrical energy available in a time-discrete manner with a peak performance on the primary side (20) of the coupling transformer (18), and
a trigger stage (14) for interrogating the active impedance on the primary side (20) of the coupling transformer (18), which impedance is a function of the switching position of the switching element (6) on the secondary side (22), and for controlling the functional group (4) as a function of this interrogated, active impedance, **characterized by that** the primary side consists of a coil.

2. Wake-up circuit according to Claim 1,
**characterized by that**
the flip-flop (12) comprises:
an energy storage device (32) for storing the electrical energy and for making this electrical energy available with the peak performance,
an electrical discharge connection (36) between the energy storage device (32) and the primary side (20) of the coupling transformer (18) for discharging the energy storage device (32) to the coupling transformer (18),
a discharge switch (38) in this electrical discharge connection (36) for disconnecting the discharge connection (36) in a time-discrete manner, and
a pulse generator (40) for controlling the discharge switch (38).

3. Wake-up circuit arrangement with a wake-up circuit (1) according to Claim 1 or 2 and with a switching element (6) connected to its switching input (26).

4. Wake-up circuit arrangement according to Claim 3,
**characterized by that**
this switching element (6) is a passive switching element whose electrical connection to the wake-up circuit (1) is present exclusively to the secondary side (22) of the coupling transformer (18).

5. Wake-up-circuit arrangement according to Claim 3 or 4,
**characterized by**
an arrangement of the secondary side (22) of the coupling transformer (18), of the switching input (26) and of the switching element (6) in a common current circuit (24) which can be closed by the switching element (6) for switching the functional group (4) in a short-circuit arrangement in order to allow electrical current to flow through this current circuit (24) substantially without resistance.

6. Wake-up-circuit arrangement according to one of Claims 3 to 5,
**characterized by**
a switching stage (16) connected in after the trigger stage (14) for switching the functional group (4).

7. Wake-up method for activating an electrical or electronic functional group (4), wherein this functional group (4) is switched by a switching element (6) via a switching input (26) galvanically separated from the functional group (4),
**characterized by** the steps
- making available (116) electrical energy in a time-discrete manner with a peak performance on a primary side (20) of the coupling transformer (18) by a flip-flop (12), wherein the primary side consists of a coil,
- inducing (122) electrical current by a magnetic field generated from the primary side (20) on a secondary side (22) of the coupling transformer (18) which secondary side is electrically connected to the switching input (26) and to the closed switching element (6),
- interrogating (126) the active impedance on the secondary side (22) of the coupling transformer (18) by a trigger stage (14), and
- switching (128) the functional group (4) as a function of the interrogated, active impedance on the primary side (20) of the coupling transformer (18).

8. Wake-up method according to Claim 7,
**characterized by** the steps
- storing (104) electrical energy in an energy storage device (32),
- making available (114) the stored energy with the peak performance,
- discharging (122) the energy storage device (32) to the primary side (20) of the coupling transformer (18) via an electrical discharge connection (36),
- controlling (118) a discharge switch (38) arranged in an electrical discharge connection (36) between the storage capacitor (32) and the coupling transformer (18) by a pulse generator (40), and
- time-discrete disconnection (110) of the discharge connection (36) by the discharge switch (38).

9. Wake-up method according to Claim 7 or 8,
**characterized by** a mechanically, electrically or electronically passive actuation (126) of the switching element (6), wherein the switched switching element (6) conducts current through substantially without resistance.

10. Wake-up method according to one of Claims 7 to 9,
**characterized by**
a flowing (124) of electrical current substantially without resistance through a current circuit (26) comprising the secondary side (22) of the coupling transformer (18), the switching input (26) and the switching element (6), which circuit is closed by the switched switching element (6).

11. Wake-up method according to one of Claims 7 to 10,
**characterized by that**
the trigger stage (14) controls a switching stage (16) which moves (130) the functional group (4) from a rest state into an operating state in response to the interrogation (126) of the active impedance on the primary side (20) of the coupling capacitor (18) with closed switching element (6) by the wake-up signal.

## Revendications

1. Circuit de réveil servant à activer un groupe de fonctions (4) électriques ou électroniques, comportant une entrée de commutation (26) galvaniquement isolée du groupe de fonctions (4), destinée au raccordement d'un élément de commutation (6) qui commute le groupe de fonctions (4),
un transformateur de liaison (18) doté d'un côté secondaire (22) raccordé électriquement à l'entrée de commutation (26) et d'un côté primaire (20) galvaniquement isolé du côté secondaire (22) et couplé par induction au côté secondaire (22),
une bascule bistable (12) raccordée électriquement au côté primaire (20), destinée à fournir, de manière discrète dans le temps, de l'énergie électrique avec une puissance de crête sur le côté primaire (20) du transformateur de liaison (18) et un étage de déclenchement (14) destiné à demander l'impédance effective sur le côté primaire (20) du transformateur de liaison (18) et dépendante de la position de commutation de l'élément de commutation (6) sur le côté secondaire (22) et destiné à commander le groupe de fonctions (4) en fonction de cette impédance effective demandée, **caractérisé en ce que** le côté primaire est constitué d'une bobine.

2. Circuit de réveil selon la revendication 1,
**caractérisé en ce que**
la bascule bistable (12) comporte :
un accumulateur d'énergie (32) destiné à stocker l'énergie électrique et à fournir cette énergie électrique avec la puissance de crête,
une connexion de décharge électrique (36) entre l'accumulateur d'énergie (32) et le côté primaire (20) du transformateur de liaison (18), destinée à la décharge de l'accumulateur d'énergie (32) vers le transformateur de liaison (18),
un commutateur de décharge (38) dans cette connexion de décharge électrique (36), destiné à la déconnexion de manière discrète dans le temps de la connexion de décharge (36) et
un générateur d'impulsions (40) destiné à la commande du commutateur de décharge (38).

3. Dispositif de circuit de réveil comprenant un circuit de réveil (1) selon la revendication 1 ou 2, et comprenant un élément de commutation (6) raccordé à l'entrée de commutation (26) de celui-ci.

4. Dispositif de circuit de réveil selon la revendication 3,
**caractérisé en ce que**
cet élément de commutation (6) est un élément de commutation passif, dont le raccordement électrique au circuit de réveil (1) existe uniquement avec le côté secondaire (22) du transformateur de liaison (18).

5. Dispositif de circuit de réveil selon la revendication 3 ou 4,
**caractérisé par**
une disposition du côté secondaire (22) du transformateur de liaison (18), de l'entrée de commutation (26) et de l'élément de commutation (6) dans un circuit électrique (24) commun, qui peut être fermé en configuration de court-circuit au moyen de l'élément de commutation (6) destiné à commuter le groupe de fonctions (4), pour laisser passer sensiblement sans résistance du courant électrique à travers ce circuit électrique (24).

6. Dispositif de circuit de réveil selon l'une des revendications 3 à 5,
**caractérisé par**
un étage de commutation (16) branché en aval de l'étage de déclenchement (14) pour la commutation du groupe de fonctions (4).

7. Procédé de réveil servant à activer un groupe de fonctions (4) électriques ou électroniques, ce groupe de fonctions (4) étant commuté au moyen d'un élément de commutation (6) par le biais d'une entrée de commutation (26) galvaniquement isolée du groupe de fonctions (4),
**caractérisé par** les étapes consistant à
- fournir (116) de manière discrète dans le temps de l'énergie électrique avec une puissance de crête sur un côté primaire (20) du transformateur de liaison (18) au moyen d'une bascule bistable (12), le côté primaire étant constitué d'une bobine,
- induire (122) du courant électrique au moyen d'un champ magnétique généré par le côté primaire (20) sur un côté secondaire (22) du transformateur de liaison (18) raccordé électriquement à l'entrée de commutation (26) et à l'élément de commutation (6) fermé,
- demander (126) l'impédance effective sur le côté secondaire (22) du transformateur de liaison (18) au moyen d'un étage de déclenchement (14) et
- commuter (128) le groupe de fonctions (4) en fonction de l'impédance effective demandée sur le côté primaire (20) du transformateur de liaison (18).

8. Procédé de réveil selon la revendication 7,
**caractérisé par** les étapes consistant à
- stocker (104) de l'énergie électrique dans un accumulateur d'énergie (32),
- fournir (114) l'énergie stockée avec la puissance de crête,
- décharger (122) l'accumulateur d'énergie (32) vers le côté primaire (20) du transformateur de liaison (18) par le biais d'une connexion de décharge électrique (36),
- commander (118) un commutateur de décharge (38) disposé dans une connexion de décharge électrique (36) entre le condensateur de stockage (32) et le transformateur de liaison (18) au moyen d'un générateur d'impulsions (40) et
- déconnecter (110) de manière discrète dans le temps la connexion de décharge (36) au moyen du commutateur de décharge (38).

9. Procédé de réveil selon la revendication 7 ou 8,
**caractérisé par** un actionnement (126) passif du point de vue mécanique, électrique ou électronique de l'élément de commutation (6), l'élément de commutation (6) commuté transmettant du courant sensiblement sans résistance.

10. Procédé de réveil selon l'une des revendications 7 à 9,
**caractérisé par**
un passage (124) sensiblement sans résistance de courant électrique dans un circuit électrique (26), qui est fermé au moyen de l'élément de commutation (6) commuté et qui comporte le côté secondaire (22) du transformateur de liaison (18), l'entrée de commutation (26) et l'élément de commutation (6).

11. Procédé de réveil selon l'une des revendications 7 à 10,
**caractérisé en ce que**
l'étage de déclenchement (14) commande un étage de commutation (16), qui, en réponse à la demande (126) de l'impédance effective sur le côté primaire (20) du condensateur de liaison (18), fait passer (130), lorsque l'élément de commutation (6) est fermé, le groupe de fonctions (4) d'un état de veille à un état de fonctionnement au moyen du signal de réveil.
